# EUROPEAN PATENT APPLICATION

(11) **EP 4 807 385 A1**
(43) Date of publication of application: **16.09.2026**
(21) Application number: 25162881.4
(22) Date of filing: 11.03.2025
(51) Int. Cl.: G01R 33/36

(54) **NMR PROBE WITH INDUCTIVELY COUPLED SAMPLE COIL AND NMR APPARATUS**

(71) Applicant: Bruker BioSpin GmbH & Co. KG, 76275 Ettlingen (DE)
(72) Inventor: BANDARA, Priyanga, 76228 Karlsruhe (DE)
(74) Representative: Kohler Schmid Möbus Patentanwälte

(57) **Abstract**

A nuclear magnetic resonance (NMR) probe (16) with a 1H channel comprising: a primary circuit with a coupling coil (L2) which is galvanically connected to an impedance port (5) for feeding RF-pluses with a frequency corresponding to 1H nuclei into the 1H channel, and a secondary circuit with a sample coil (L1) for applying and receiving RF pulses to/from a sample and at least one tuning element (6, 7) which is galvanically connected to the sample coil (L1) for tuning a first resonance circuit of the 1H channel, wherein the coupling coil (L2) is inductively coupled to the sample coil (L1) to couple the RF-signals into the sample coil (L1), is characterized in that the coupling coil (L2) is arranged co-centrically and symmetrically to the sample coil (L1). A more efficient inductive coupling can be provided in order to apply a strong RF magnetic field to the sample, especially on the 1H channel without degrading the sensitivity of multi-tuned single coil NMR-probes, in particular in MAS applications.

## Description

### Field of invention

The invention concerns Nuclear magnetic resonance (NMR) probe with a 1H channel comprising: a primary circuit with a coupling coil which is galvanically connected to an impedance port for feeding RF-pluses with a frequency corresponding to 1H nuclei into the 1H channel, and a secondary circuit with a sample coil for applying and receiving RF pulses to/from a sample and at least one tuning element which is galvanically connected to the sample coil for tuning a first resonance circuit of the 1H channel, wherein the coupling coil is inductively coupled to the sample coil to couple the RF-signals into the sample coil.

### Background of the invention

An according NMR probe is disclosed in [US239].

NMR probes are operated at specific resonant frequencies. For adjusting the resonant circuit to resonate at a specific frequency, tuning elements are used in order to optimize the performance of the resonant circuit at that frequency.

The resonant circuit of the NMR probe is electrically connected to a pulse generator, detector etc. via an impedance port. For minimizing losses during transmittance of the signals, the impedance of the resonant circuit is to be matched to the impedance of the pulse generator. This can be realized by using matching capacitors in order to minimize reflections/signal losses.

The main task in NMR-MAS (magic angel spinning) applications is to apply strongest possible RF magnetic field (B1) to the sample especially on the 1H channel (which is the channel with the highest frequency) without degrading the sensitivity of multi-tuned MAS single-coil NMR probes. A voltage-balanced circuit enables to use higher RF magnetic field compared to unbalanced circuits.

A known solution that helps with optimizing the voltage distribution in the circuit is to optimize the sample coil configurations. [US739] discloses such an NMR sample excitation coil for high voltages. The coil has a first end connected through a first balancing inductor to ground and a second end connected through a second balancing inductor to a low-frequency capacitor tuning and matching network. The two balancing inductors each have inductance less than 50% but greater than 10% than the excitation coil. The disadvantage of this arrangement is that the coil modification requires attaching extra inductors directly to the sample coil that reduces the sensitivity of the probe.

Further, it is known to increase the voltage / current withstanding of critical components of NMR probes, such as coils and capacitors. [EP445] discloses a multiple tuning circuit which is for use in a nuclear magnetic resonance spectrometer and which has a resonant circuit having improved resistance to RF voltages. If high RF power is injected, electric discharge is unlikely to occur. A sample coil and inductors together form a balanced resonant circuit where the RF amplitude voltage becomes zero near the center point of the sample coil. The disadvantage of this arrangement is that the voltage balance of the circuit is not maintained under different sample coil loading conditions. Depending on sample properties such as dielectric constant and / or the electric conductivity, the voltage distribution of the circuit will deviate from the optimum. The balanced condition will not maintain when samples with different dielectric constants or when lossy samples are used. In addition, the voltage balance is not maintained for different tuning conditions.

[US239] describes a resonant circuit for NMR devices whereby the sample coil is inductively coupled to a second inductance of a secondary resonating circuit in order to match the circuit to 50 Ω impedance. However, the disclosed inductive coupling does not lead to a balanced circuit and higher voltage stability that will allow higher B1 fields. [US239] does not describe any adaptation that would allow the voltage balance of the circuit to be improved.

[EP110] uses inductive coupling for multiple resonance tuning in a nuclear magnetic resonance probe. Additional inductors are added to the parts of the circuit that have high currents, which has a detrimental effect on efficiency. The RF circuit components are moved away from the sample coil to improve some aspects of the probe performance such as resolution. However, that does not include improving the voltage balance to get higher B1 fields.

### Object of the invention

It is an object of the invention to provide a more efficient inductive coupling in order to apply a strong RF magnetic field (B1) to the sample, especially on the 1H channel without degrading the sensitivity of multi-tuned single coil NMR-probes, in particular in MAS applications.

### Summary of the invention

This object is achieved in that the coupling coil is arranged co-centrically and symmetrically to the sample coil.

The inventive co-centric and symmetric arrangement allows a symmetric coupling of RF pulses from the coupling coil to the sample coil and thus a balanced feeding, i.e. balanced voltage across the coupling loop, of RF pulses into the 1H channel. This balanced feeding contributes to maintain the voltage balance in the circuit.

In contrast to known current NMR probes, the current in the coupling loop of the inventive NMR probe will be very low, making it a more efficient way of inductively coupling,

The coupling coil is part of a primary circuit, wherein the sample coil is part of a secondary circuit, wherein components of the primary and the secondary circuit form the resonant circuit. Preferably, the resonant circuit is voltage-balanced. According to the invention, the HF pulses are fed into the secondary circuit symmetrically to the sample coil via the coupling coil, thereby maintaining the voltage balance even when lossy samples are used, while keeping the circuitry simple. Thus, the inventive simple sample coil design minimizes the circuit overhead, while maintaining voltage balance in all channels of the probe, irrespective of the properties of the sample such as the dielectric constant and the conductivity that can degrade the voltage balance of the circuit.

In case of samples with different dielectric constants or in case of lossy samples, or both, the resonance frequency of the resonant circuit and the critical coupling condition is affected. By using inductive coupling, the primary circuit can be re-matched to the impedance port without affecting the voltage-balance of the secondary circuit. The concentric and symmetric arrangement ensures a balanced feeding of the RF pulses. As a result, higher B1-fields can be realized for a given applied voltage.

The coupling coil is connected in series with the impedance port and two capacitors, with one capacitor electrically connected to each side of the coupling coil in order to provide a balanced primary circuit matched to the impedance port.

The coupling coil is designed and arranged in such a way that it inductively couples the RF radiation generated by the RF pulse generator symmetrically into the oscillating circuit via the sample coil.

The sample coil is configured to excite nuclear spins of an NMR sample and to detect the radiation from the excited sample nuclei.

The coupling coil is preferably arranged around the sample coil. Most preferably the coupling coil has circular loop(s). Other shapes are also possible, such as square, or pentagon, or even an irregular shape, but a concentric circular coupling coil would give the best coupling.

The impedance port is to be connected to an RF pulse generator for generating RF-signals.

In a preferred embodiment, the coupling coil is a single loop. In MAS probes the coils have to be in a restricted space of a stator. So, having a single loop makes the practical implementation easier. However, if stronger coupling is needed, a multi-turn coupling coil could be used instead of a single loop.

Most preferably the sample coil is a solenoid with a longitudinal axis and the coupling coil is arranged coaxial to the sample coil and centered with respect to longitudinal axis.

In order to have a balanced secondary circuit it is preferred to provide two tuning elements, wherein the sample coil is electrically, in particular galvanically, connected to the tuning elements between them.

In a preferred embodiment, the tuning elements are tunable transmission lines, and the tunable transmission lines are mechanically coupled to each other for synchronized variation of resonance frequency of the transmission lines. The transmission lines are preferably identical, in particular in length and diameter. The preferred electrical length of the transmission lines is (or is very close to) one half of the wavelength corresponding to the 1H resonance frequency of the probe, used in an open circuit configuration. However, it is possible to use transmission lines having electrical lengths that are integer multiples of half the wavelength corresponding to the 1H resonance frequency of the probe, such as λ/2, 2 λ/2, 3λ/2, 4λ/2,...nλ/2, where n is an integer. It is also possible to use transmission lines having electrical lengths that are odd integer multiples of quarter of the wavelength corresponding to the 1H resonance frequency of the NMR probe. Such as λ/4, 3λ/4, 5λ/4, 7λ/4,...nλ/4, where n is an odd integer. However, when these lengths are used, the transmission lines should be in a short-circuit configuration.

Elements that are designed to change the resonance frequency of both transmission lines are mechanically coupled. This allows the 1H channel to be tuned while maintaining voltage balance across the sample coil irrespective the sample properties that can influence the voltage balance of the secondary circuit.

Alternatively or additionally, the tuning elements can also be variable capacitors (i.e. capacitors with variable capacities) that are mechanically coupled to each other in order to change the capacity of the capacitors synchronously. However, transmission lines have lower losses compared to other options, and therefore would give the best results.

The transmission lines are preferably coaxial cables, each comprising a coaxial cable sheath and an insertable dielectric element, wherein coupling of the transmission lines is realized by mechanically coupling the insertable dielectric elements to each other in order to synchronize insertion of the insertable dielectric elements into and removal of the insertable dielectrics out of the coaxial cable sheaths. The dielectrics are insertable into hollow cylindrical elements of the coaxial cable, wherein the mechanic coupling moves the dielectric material synchronously. The mechanical coupling can be realized by a mechanical coupling element, e.g. a rigid plate that is directly or indirectly connected to the dielectrics.

For matching the resonant circuit to the impedance port, it is preferred that the primary circuit comprises a variable matching capacitor connected in series between the impedance port and the coupling coil for matching impedance of the coupling coil to the impedance of an RF pulse generator, and a feeding circuit balancing capacitor connected in series with the coupling coil on the side of the coil opposite the impedance port. The feeding circuit balancing capacitor can be non-variable. However, with a variable feeding circuit balancing capacitor there will be a measurable improvement in performance. The capacity of the variable matching capacitor and the feeding circuit balancing capacitor are similar in value in order to provide a balanced primary circuit. However, even if the values of the variable matching capacitor and the feeding circuit balancing capacitor differ by a large factor, the inventive coil geometry ensures that the influence on the voltage balance of the primary circuit and as a result to the whole resonant circuit would be very small.

In a highly preferred embodiment, the NMR probe comprises at least one further channel, the further channel comprising a further impedance port galvanically connected to the secondary circuit for feeding RF-pluses of a further frequency into the further channel, wherein the frequency of the RF-pulses of the further channel corresponds to nuclei with a lower gyromagnetic ratio compared to 1H, and a further variable tuning capacitor which is electrically connected between the sample coil of the secondary circuit and an earth contact for tuning a further resonant circuit of the further channel. Thus, a multiple tuning circuit is provided. The further impedance port of the further channels to be connected to a further RF pulse generator.

The further secondary circuit preferably comprises a voltage balance capacitor, wherein the sample coil is electrically connected between the further variable tuning capacitor and the voltage balance capacitor. The voltage balance capacitor may have a fixed capacity.

In a preferred embodiment, that the voltage balance capacitor is an additional variable tunable capacitor, and the further variable tunable capacitor and the additional variable tunable capacitor are mechanically coupled for synchronized variation of their capacities. The mechanical coupling is realized by a mechanical coupling element. For variable capacitors operated by rotational motion, the coupling can be done using gears as mechanical coupling elements. For variable capacitors operated by linear motion, the coupling can be done with a beam structure as mechanical coupling element.

In case of a multi-tuned NMR probe, it is preferred that a stop circuit is electrically connected between the 1H channel and the further channel. The stop circuit is a filter circuit that prevent the energy of the 1H channel from entering the other channels and the components below these filter circuits. Preferably, for each further channel one stop circuit is provided. If transmission lines are used for tuning the 1H circuit one stop circuit can be omitted.

The advantages of the inventive NMR probe are best achieved when used as nuclear magnetic resonance magic angle spinning (NMR-MAS) probe, since MAS requires high RF magnetic fields.

The invention also concerns an NMR-Apparatus for analysis of a sample, the apparatus comprising a superconducting magnet, an RF pulse generator for generating RF frequency signals, a detector for detecting signals received from the sample, and an NMR-MAS-probe as described above.

The inventive NMR probe uses symmetric inductive coupling to provide RF signals for the 1H resonance circuit. This ensures that voltage balance can be maintained within the 1H resonance circuit even when lossy samples are used, since the primary circuit of the 1H channel can be re-matched to the impedance port (resulting in an unbalanced primary circuit) without affecting the voltage-balance of the secondary circuit. This means that a voltage-balanced 1H resonant circuit can be established and maintained with little effort.

Further advantages of the invention can be derived from the description and the drawings. Also, the above-mentioned and the still further described features can be used according to the invention individually or in any combination. The embodiments shown and described are not to be understood as a conclusive list, but rather have an exemplary character for the description of the invention.

### Brief description of the drawings

- Fig. 1: shows a mixed representation of circuit diagram and figurative illustration of an inventive HXY-NMR probe with mechanically coupled tuning elements only in the 1H channel, wherein the 1H channel is tuned by using coupled **variable transmission lines.**
- Fig. 2: shows the circuit diagram of embodiment of Fig. 1.
- Fig. 3: shows mechanical coupled tunable transmission lines.
- Fig. 4: shows a mixed representation of circuit diagram and figurative illustration of an inventive HXY-NMR probe with mechanically coupled tuning elements in all channels, wherein the 1H channel is tuned by using coupled **variable transmission lines.**
- Fig. 5: shows a circuit diagram of an inventive HXY-NMR probe wherein the 1H channel is tuned by using coupled **variable capacitors.**
- Fig. 6: shows mechanical coupled tuning capacitors operated by linear motion.
- Fig. 7: shows mechanical coupled tuning capacitors operated by rotational motion.
- Fig. 8: shows a schematic structure of an inventive NMR-Apparatus.

### Detailed description of the drawings

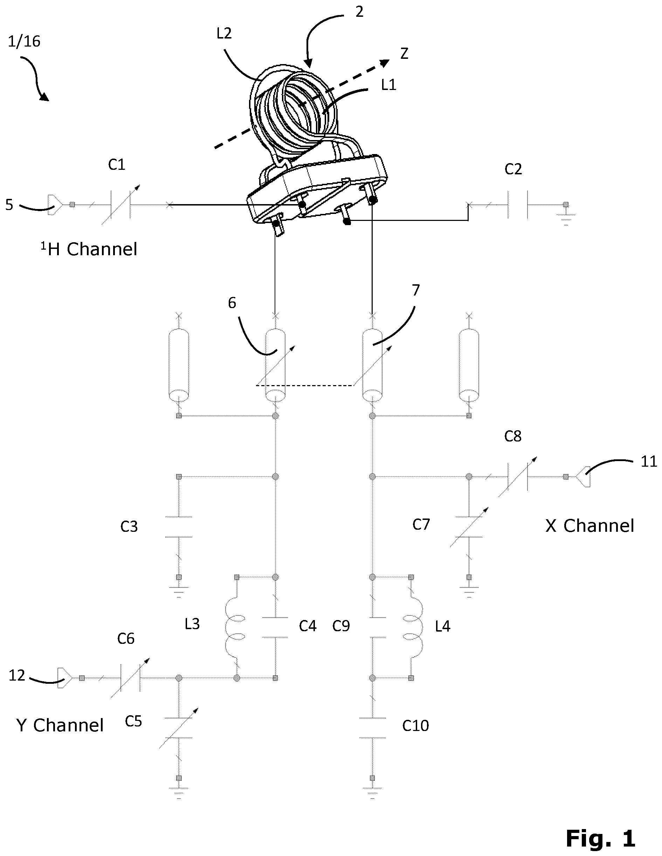

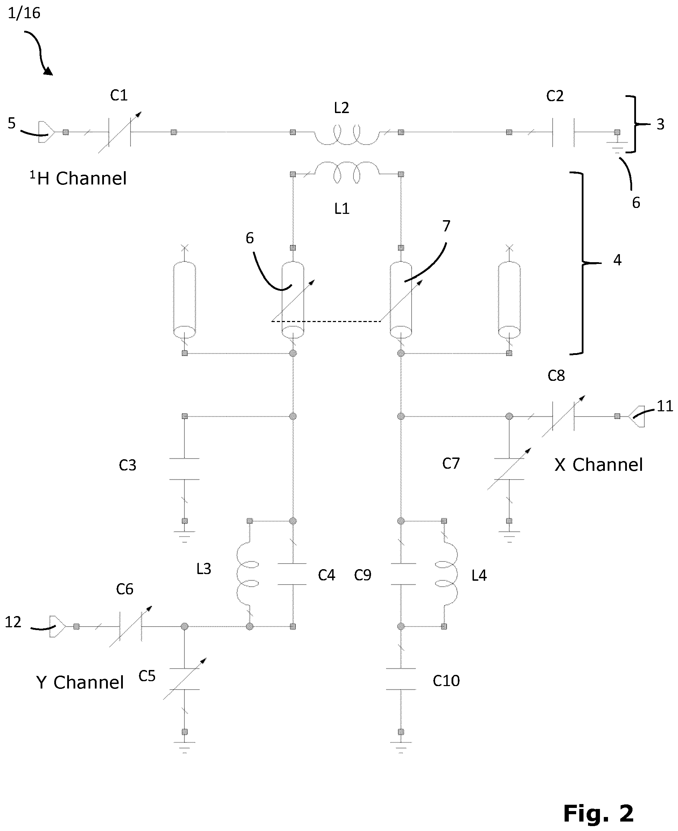

**Fig. 1** shows a first embodiment of a probe circuit 1 of the inventive NMR probe with a 1H channel and two further channels (X channel and Y channel) with a figurative representation of an inventive coil configuration **2.** **Fig. 2** shows an according circuit diagram of probe circuit 1.

The 1H channel comprises a primary circuit **3** and a secondary circuit **4,** which are inductively coupled via the coil configuration 2 (s. Fig. 2). The inventive coil configuration 2 comprises a sample coil **L1** and a coupling coil L2. In the specific embodiment shown in Fig. 1, the sample coil L1 is designed as a solenoid with a longitudinal axis z and the coupling coil L2 is designed as a single loop, wherein the coupling coil L2 is arranged radially around the sample coil L1 and symmetrically to the sample coil L1. Specifically, the coupling coil L2 is arranged coaxially to the sample coil L1 and centered with respect to the longitudinal axis z of the sample coil L1. Thereby a balanced feeding of the RF-pulses from the primary circuit 3 to the secondary circuit 4 can be realized.

The primary circuit 3 comprises the coupling coil L2 and a first impedance port **5,** for feeding RF pulses into the 1H resonance circuit, a variable matching capacitor **C1** and a feeding circuit balancing capacitor C2. The variable matching capacitor C1 is electrically connected between the impedance port 5 and the coupling coil L2. The variable matching capacitor C1 is responsible for impedance matching of the 1H resonance circuit to the impedance port 5 (respectively an RF pulse generator connected to said impedance port 5), i.e. to critically couple the 1H resonance circuit to an external circuitry (not shown in Fig. 1 and Fig. 2). In other words, variable matching capacitor C1 provides ideal coupling condition that allows the most efficient transfer of energy between the external circuitry and the probe circuitry. The feeding circuit balancing capacitor C2 is electrically connected between the coupling coil L2 and ground. The capacity of the feeding circuit balancing capacitor C2 and the matching capacitor C1 are about the same value in order to provide voltage balance within the primary circuit 3. The primary circuit 3 and the secondary circuit 4 together form a 1H resonant circuit of the 1H channel.

The secondary circuit 4 comprises the sample coil L1 for applying RF pulses to a sample to be examined and tuning elements **6, 7.** The tuning elements 6, 7 and the sample coil L1 are electrically connected in series. In the specific embodiment shown in Fig. 1 and Fig. 2, the sample coil L2 is connected between two identical tuning elements 6, 7. The tuning elements 6, 7 used in this specific embodiment are tunable transmission lines 6, 7, i.e. transmission lines 6, 7 whose resonance frequency can be varied. The transmission lines 6, 7 are mechanically coupled (indicated by a dashed line in Fig. 1 and Fig. 2), such that tuning can be synchronized. I. e. the resonant frequencies of the two transmission lines 6, 7 can be changed simultaneously by the same amount, thereby providing a voltage balanced secondary circuit 4.

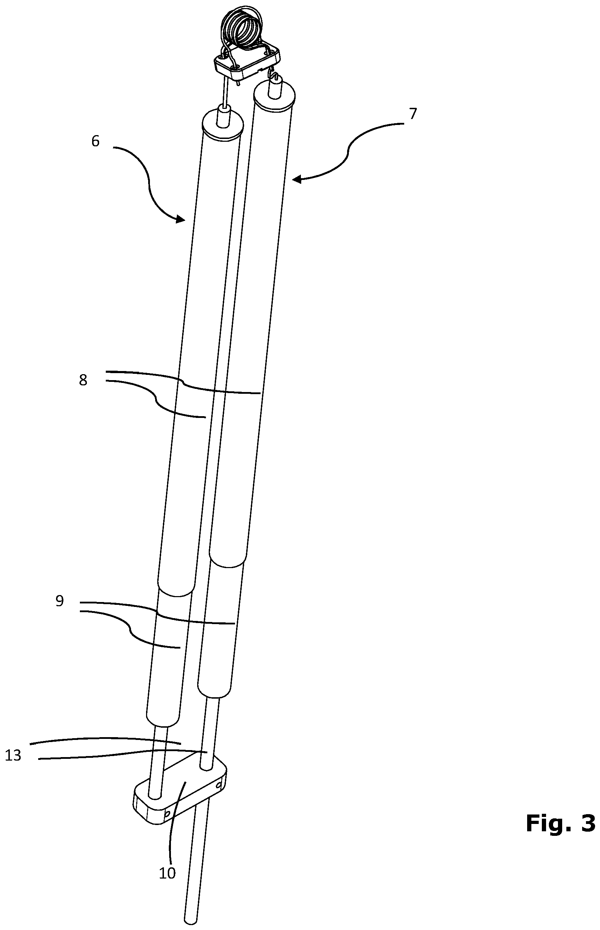

**Fig. 3** shows an example of how the mechanical coupling of two transmission lines 6, 7 can be realized. Two tunable transmission lines 6, 7 each having a coaxial cable sheath **8** and a cylindrical dielectric element **9,** which is insertable into the coaxial cable sheath 8. The dielectric elements 9 of the two transmission lines 6, 7 are rigidly connected via a crossbar 10 (and actuator elements **13** connecting the crossbar with the dielectric elements 9), thereby ensuring synchronized insertion.

The further channels each comprises a further impedance port **11, 12** for feeding RF pulses into an X resonance circuit and a Y resonant circuit respectively, a variable matching capacitor **C8, C6,** further tunable elements (variable capacitors **C7, C5)** connected to ground and a voltage balance capacitor **C3, C10.** Instead of transmission lines, variable capacitors C7, C5 are used as further tunable elements. Variable capacitors C7, C5 are preferred in the further channels, since the frequencies of the further channels are much lower than that of the 1H channel, which would require much longer transmission lines that would not fit inside the NMR probe.

No balanced feeding is provided for the further channels in the shown embodiments. This is because the further channels are generally operated at lower frequencies than the 1H channel, i.e. the further channels are used for excitation of nuclei with a lower gyromagnetic ratio compared to 1H, e.g. C (carbon), N (nitrogen) nuclei. Due to the lower gyromagnetic ratio, the experienced losses due to lossy samples are lower in the further channels than in the 1H channel. A balanced feeding is therefore not so important in the further channels, since a non-balanced feeding in the further channels does not affect the performance of the NMR probe critically.

In order to prevent the energy of the 1H channel from entering the further channels a pair of stop circuits L3-C4, L4-C9 are provided in the circuit. One stop circuit is connected between the tuning element 6 of the 1H channel and the impedance port of the Y channel and the other stop circuit is electrically connected between the tuning element 7 of the 1H channel and the voltage balance capacitor C10 of the Y channel.

The stop circuits L3-C4, L4-C9 are electrically connected to the 1H channel. The stop circuits L3-C4, L4-C9 are filter circuits, which on the one hand prevent the energy of the 1H channel from entering the Y channel and the components below these stop circuits L3-C4, L4-C9, and on the other hand allow energy from the X channels to be transferred to the sample coil L1.

In the embodiment shown in Fig. 1 and Fig. 2, the voltage balance capacitor **C3, C10** are capacitors with fixed capacity, i.e. tuning can be carried out in a balanced way only for a specific frequency. Therefore, the embodiment shown in Fig. 1 and Fig. 2 is ideal for triple resonance fixed frequency probes such as HCN probes. However, this probe circuit 1 can be used in triple resonance double broadband probes (HXY) as well, if higher B1 fields are only needed on the 1H channel.

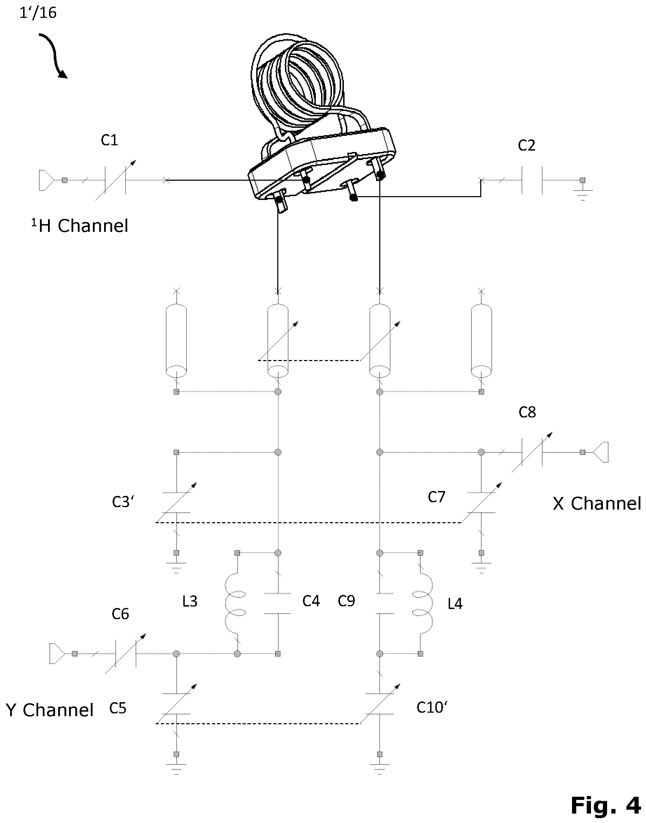

Instead of voltage balance capacitors C3, C10 with fixed capacities, additional variable tuning capacitors **C3', C10'** (i.e. capacitors with variable capacities) can be provided in a probe circuit **1'** as shown in **Fig. 4** which are used for tuning the further channels together with the further variable tuning capacitors C7, C5. In each further channel, the tuning capacitor C7, C5 and the additional tuning capacitor C3', C10' are mechanically coupled in order to synchronize the tuning of the resonant circuit of the according further channel. The probe circuit 1' shown in Fig. 4 is preferably used in triple resonance double broadband probes HXY.

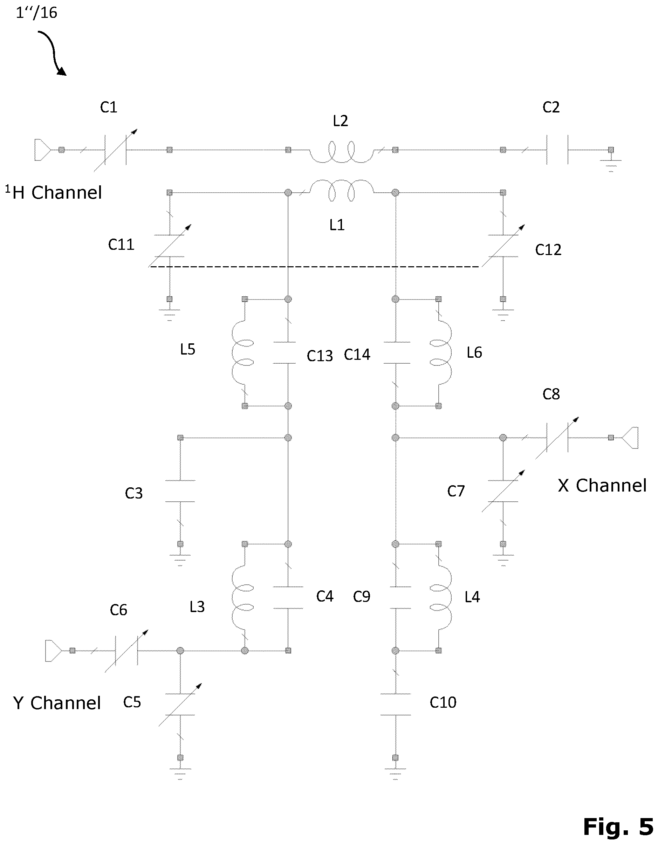

Analogue to the further channels, the tuning of the 1H channel can be done using mechanically coupled capacitors **C11, C12** instead of using tunable transmission lines 6, 7. An according probe circuit **1"** is shown in **Fig. 5****.**

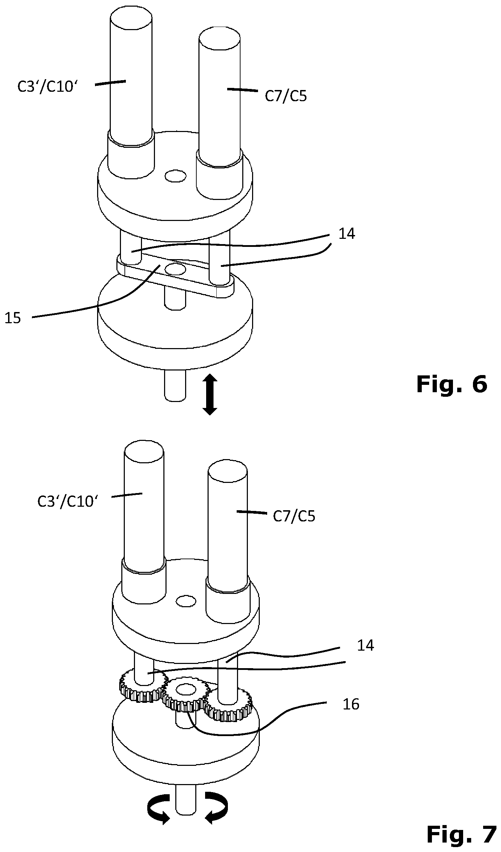

The mechanical coupling of the tuning capacitor C7, C5 with the additional tuning capacitor C3', C10' can be achieved in different ways, e.g. by moving insertable dielectrics via actuator elements **14** by linear motion using a crossbar 15 that is rigidly connected to the actuator elements 14, as shown in **Fig. 6****,** or by rotational motion using a common gearwheel **15** simultaneously rotating the actuator elements 14, as shown in **Fig. 7****.**

Here also, stop circuits L3-C4, L4-C9 are provided in order to prevent the energy of the 1H channel from entering the Y channel. Yet, in contrast to the circuits 1, 1' shown in Fig. 1, Fig. 2 and Fig. 4, where the transmission lines dimensions are selected so that they stop energy in the 1H resonance circuitry going into other parts of the circuit, the circuit 1" shown in Fig. 5 comprises two more stop circuits **L5-C13, L6-C14,** which are electrically connected downstream the 1H channel but upstream the stop circuits L3-C4, L4-C9 in order to prevent the energy of the 1H channel from entering the X channel.

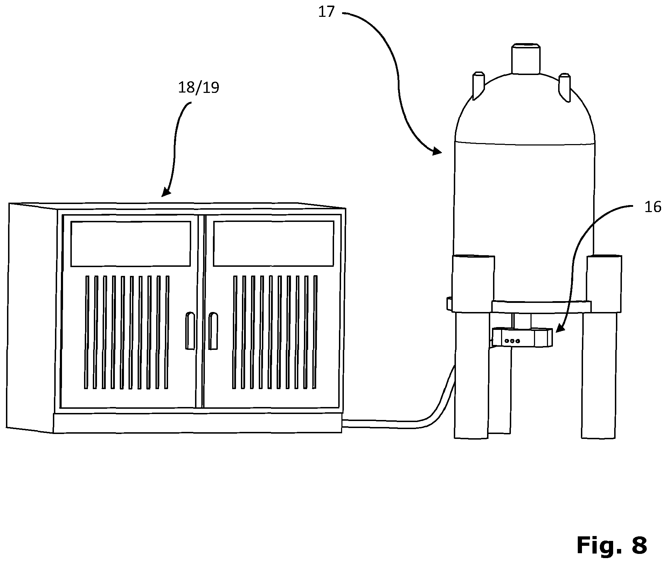

**Fig. 8** shows an NMR apparatus **15** with the inventive NMR probe **16.** The NMR apparatus 15 comprises a superconducting magnet **17** into which the NMR probe 16 can be inserted in order to excite nuclei of a sample to be examined. An RF pulse generator 18 is electrically connected to the impedance ports 5, 11, 12 of the NMR probe 16 for generating RF frequency signals and for feeding them into the NMR probe 16. Further, a detector **19** is electrically connected to the impedance ports 5, 11, 12 of the NMR probe 16 for detecting signals received from the sample.

### List of reference signs

- 1, 1', 1": NMR probe circuit
- 2: coil configuration
- 3: primary circuit of 1H channel
- 4: secondary circuit of 1H channel
- 5: impedance port of 1H channel
- 6, 7: 1H tuning elements (tunable transmission lines)
- 8: coaxial cable sheaths of tunable transmission lines
- 9: insertable dielectrics of tunable transmission lines
- 10: crossbar of tunable transmission lines
- 11: further impedance port of X channel
- 12: further impedance port of Y channel
- 13: actuator elements of tunable transmission lines
- 14: actuator elements of tunable capacitors
- 15: NMR apparatus
- 16: NMR probe
- 17: superconducting magnet
- 18: RF pulse generator
- 19: detector
- C1: variable matching capacitor in 1H channel
- C2: feeding circuit balancing capacitor
- C3: voltage balance capacitor in X channel
- C3': additional variable tunable capacitor in X channel (variable voltage balance capacitor)
- C5: further variable tuning capacitor in Y channel (further tuning element)
- C6: variable matching capacitor in X channel
- C7: further variable tuning capacitor in X channel (further tuning element)
- C8: variable matching capacitor in Y channel
- C10: voltage balance capacitor in Y channel
- C10': additional variable tunable capacitor in Y channel (variable voltage balance capacitor)
- C11, C12: variable tuning capacitors in 1H channel (tuning elements)
- L1: sample coil
- L2: coupling coil
- L5-C13, L6-C14: stop circuits for X channel
- L3-C4, L4-C9: stop circuits for Y channel
- z: longitudinal axis of solenoidal sample coil

### List of cited documents

[US739] US 5 162 739 A
[EP445] EP 1 298 445 A2
[US239] US 10 908 239 B1
[EP110] EP 3 403 110 B1

## Claims

1. Nuclear magnetic resonance (NMR) probe (16) with a 1H channel comprising:
a primary circuit (3) with a coupling coil (L2) which is galvanically connected to an impedance port (5) for feeding RF-pluses with a frequency corresponding to 1H nuclei into the 1H channel, and
a secondary circuit (4) with a sample coil (L1) for applying and receiving RF pulses to/from a sample and at least one tuning element (6, 7; C11, C12) which is galvanically connected to the sample coil (L1) for tuning a first resonance circuit of the 1H channel,
wherein the coupling coil (L2) is inductively coupled to the sample coil (L1) to couple the RF-signals into the sample coil (L1),
**characterized in**
**that** the coupling coil (L2) is arranged co-centrically and symmetrically to the sample coil (L1).

2. NMR probe (16) according to claim 1, **characterized in that** the coupling coil (L2) is a single loop.

3. NMR probe (16) according to one of the preceding claims, **characterized in that** the sample coil (L1) is a solenoid with a longitudinal axis (z) and the coupling coil is arranged coaxial to the sample coil and centered with respect to longitudinal axis (z).

4. NMR probe (16) according to one of the preceding claims, **characterized in that** two tuning elements (6, 7; C11, C12) are provided, wherein the sample coil (L1) is electrically, in particular galvanically, connected to the tuning elements (6, 7; C11, C12) between them.

5. NMR probe (16) according claims 4, **characterized in**
**that** the tuning elements (6, 7) are tunable transmission lines, and
**that** the tunable transmission lines (6, 7) are mechanically coupled to each other for synchronized variation of resonance frequency of the transmission lines (6, 7).

6. NMR probe (16) according to claim 5, **characterized in that** the transmission lines (6, 7) are coaxial cables, each comprising a coaxial cable sheath (8) and an insertable dielectric element (9), wherein coupling of the transmission lines (6, 7) is realized by mechanically coupling the insertable dielectric elements (9) to each other in order to synchronize insertion of the insertable dielectric elements (9) into and removal of the insertable dielectrics out of the coaxial cable sheaths (8).

7. NMR probe (16) according to one of the preceding claims, **characterized in that** the primary circuit (3) comprises a variable matching capacitor (C1) connected in series between the impedance port (5) and the coupling coil (L2) for matching impedance of the coupling coil (L2) to the impedance of an RF pulse generator (18), and a feeding balance capacitor (C2) connected in series with the coupling coil (L2) on the side of the sample coil (L1) opposite the impedance port.

8. NMR probe (16) according to one of the preceding claims, **characterized in that** the NMR probe (16) comprises at least one further channel, the further channel comprising
a further impedance port (11, 12) galvanically connected to the secondary circuit (4) for feeding RF-pluses of a further frequency into the further channel, wherein the frequency of the RF-pulses of the further channel corresponds to nuclei with a lower gyromagnetic ratio compared to 1H, and a further variable tuning capacitor (C7; C5) which is electrically connected between the sample coil (L2) of the secondary circuit (4) and an earth contact for tuning a further resonant circuit of the further channel.

9. NMR probe (16) according to claim 8, **characterized in that** the further channel comprises a voltage balance capacitor (C3, C3', C10, C10'), wherein the sample coil (L1) is electrically connected between the further variable tuning capacitor (C8, C5) and the voltage balance capacitor (C3, C10) .

10. NMR probe (16) according to claim 9, **characterized in that** the voltage balance capacitor (C3', C10'), is an additional variable tunable capacitor (C3', C10'), and that the further variable tunable capacitor (C7, C5) and the additional variable tunable capacitor (C3', C10') are mechanically coupled for synchronized variation of their capacities.

11. NMR probe (16) according to one of the claims 8 to 10, **characterized in that** a stop circuit (L5-C13, L6-C14, L3-C4, L4-C9) is electrically connected between the 1H channel and the further channel.

12. NMR probe (16) according to one of the preceding claims **characterized in that** it is a nuclear magnetic resonance magic angle spinning (NMR-MAS) probe.

13. NMR-Apparatus (15) for analysis of a sample, the apparatus comprising a superconducting magnet (17), an RF pulse generator (18) for generating RF frequency signals, a detector (19) for detecting signals received from the sample, and an NMR probe (16) according to one of the preceding claims.

## Amended claims

### Amended claims in accordance with Rule 137(2) EPC.

1. Nuclear magnetic resonance (NMR) probe (16) with a 1H channel comprising:
a primary circuit (3) with a coupling coil (L2) which is galvanically connected to an impedance port (5) for feeding RF-pluses with a frequency corresponding to 1H nuclei into the 1H channel, and
a secondary circuit (4) with a sample coil (L1) for applying and receiving RF pulses to/from a sample and at least one tuning element (6, 7; C11, C12) which is galvanically connected to the sample coil (L1) for tuning a first resonance circuit of the 1H channel,
wherein the coupling coil (L2) is inductively coupled to the sample coil (L1) to couple the RF-signals into the sample coil (L1),
**characterized in**
**that** the coupling coil (L2) is arranged co-centrically and symmetrically to the sample coil (L1),
**that** the sample coil (L1) is a solenoid with a longitudinal axis (z) and the coupling coil is arranged coaxial to the sample coil and centered with respect to longitudinal axis (z).

2. NMR probe (16) according to claim 1, **characterized in that** the coupling coil (L2) is a single loop.

3. NMR probe (16) according to one of the preceding claims, **characterized in that** two tuning elements (6, 7; C11, C12) are provided, wherein the sample coil (L1) is electrically, in particular galvanically, connected to the tuning elements (6, 7; C11, C12) between them.

4. NMR probe (16) according claim 3, **characterized in**
**that** the tuning elements (6, 7) are tunable transmission lines, and
**that** the tunable transmission lines (6, 7) are mechanically coupled to each other for synchronized variation of resonance frequency of the transmission lines (6, 7).

5. NMR probe (16) according to claim 4, **characterized in that** the transmission lines (6, 7) are coaxial cables, each comprising a coaxial cable sheath (8) and an insertable dielectric element (9), wherein coupling of the transmission lines (6, 7) is realized by mechanically coupling the insertable dielectric elements (9) to each other in order to synchronize insertion of the insertable dielectric elements (9) into and removal of the insertable dielectrics out of the coaxial cable sheaths (8).

6. NMR probe (16) according to one of the preceding claims, **characterized in that** the primary circuit (3) comprises a variable matching capacitor (C1) connected in series between the impedance port (5) and the coupling coil (L2) for matching impedance of the coupling coil (L2) to the impedance of an RF pulse generator (18), and a feeding balance capacitor (C2) connected in series with the coupling coil (L2) on the side of the sample coil (L1) opposite the impedance port.

7. NMR probe (16) according to one of the preceding claims, **characterized in that** the NMR probe (16) comprises at least one further channel, the further channel comprising
a further impedance port (11, 12) galvanically connected to the secondary circuit (4) for feeding RF-pluses of a further frequency into the further channel, wherein the frequency of the RF-pulses of the further channel corresponds to nuclei with a lower gyromagnetic ratio compared to 1H, and a further variable tuning capacitor (C7; C5) which is electrically connected between the sample coil (L2) of the secondary circuit (4) and an earth contact for tuning a further resonant circuit of the further channel.

8. NMR probe (16) according to claim 7, **characterized in that** the further channel comprises a voltage balance capacitor (C3, C3', C10, C10'), wherein the sample coil (L1) is electrically connected between the further variable tuning capacitor (C8, C5) and the voltage balance capacitor (C3, C10) .

9. NMR probe (16) according to claim 8, **characterized in that** the voltage balance capacitor (C3', C10'), is an additional variable tunable capacitor (C3', C10'), and that the further variable tunable capacitor (C7, C5) and the additional variable tunable capacitor (C3', C10') are mechanically coupled for synchronized variation of their capacities.

10. NMR probe (16) according to one of the claims 7 to 9, **characterized in that** a stop circuit (L5-C13, L6-C14, L3-C4, L4-C9) is electrically connected between the 1H channel and the further channel.

11. NMR probe (16) according to one of the preceding claims **characterized in that** it is a nuclear magnetic resonance magic angle spinning (NMR-MAS) probe.

12. NMR-Apparatus (15) for analysis of a sample, the apparatus comprising a superconducting magnet (17), an RF pulse generator (18) for generating RF frequency signals, a detector (19) for detecting signals received from the sample, and an NMR probe (16) according to one of the preceding claims.
